# FASCICULE DE BREVET EUROPEEN

(11) **EP 3 571 718 B1**
(45) Date de publication et mention de la délivrance du brevet: **25.11.2020**
(21) Numéro de dépôt: 18703072.1
(22) Date de dépôt: 23.01.2018
(51) Int. Cl.: H01L 25/065, H01L 21/60, H01L 21/98

(54) **PROCÉDÉ DE FABRICATION D'UN DISPOSITIF ÉLECTRONIQUE**
VERFAHREN ZUR HERSTELLUNG EINER ELEKTRONISCHEN VORRICHTUNG
METHOD FOR MANUFACTURING AN ELECTRONIC DEVICE

(30) Priorité: 23.01.2017 FR 1750546
(43) Date de publication de la demande: 27.11.2019
(73) Titulaire: Commissariat à l'Énergie Atomique et aux Énergies Alternatives, 75015 Paris (FR)
(72) Inventeur: CARTIER, Mathilde, 38000 Grenoble (FR); ARENE, Emmanuel, 38330 Biviers (FR); BRUN, Jean, 38800 Champagnier (FR); DESCOURS, Pierre, 38500 Coublevie (FR); HAGUET, Julie, 38100 Grenoble (FR)
(74) Mandataire: Talbot, Alexandre
(86) Numéro de dépôt international: PCT/FR2018/050157
(87) Numéro de publication internationale: WO 2018/134547

(56) Documents cités:
- EP-A1- 3 093 886
- EP-A2- 2 339 618
- JP-A- S59 155 162
- US-A1- 2003 207 516
- US-A1- 2009 321 950
- US-A1- 2016 358 892

## Description

### Domaine technique de l'invention

L'invention est relative à un procédé de fabrication d'un dispositif électronique et notamment d'une puce à circuit intégré.

### État de la technique

De nombreux documents décrivent la réalisation de puces à circuit intégré qui sont reliées électriquement et mécaniquement à des fils électriquement conducteurs.

Le brevet US 8723312 décrit différentes architectures de puces. Ces puces comportent un premier substrat séparé d'un deuxième substrat par une entretoise. L'entretoise présente une largeur inférieure aux premier et deuxième substrats de manière à définir une ou deux rainures latérales qui sont utilisées pour réaliser l'encastrement d'un fil électriquement conducteur.

Le document WO2008/025889 décrit une puce microélectronique comportant deux faces principales parallèles et des faces latérales opposées. Au moins une des faces latérales comporte une rainure, munie d'un élément de connexion électrique formant un logement pour un élément filaire ayant un axe parallèle à l'axe longitudinal de la rainure.

De cette manière, le circuit intégré qui est présent dans le premier substrat est mis en contact électrique avec un élément extérieur au moyen du fil électriquement conducteur qui est inséré dans la rainure.

Le brevet US 8723312 décrit également un procédé d'insertion d'un élément filaire à l'intérieur de la rainure.

Pour un bon fonctionnement du circuit intégré, les signaux en provenance ou à destination du circuit intégré doivent transiter au moyen du fil électriquement conducteur. La connexion électrique entre le fil électriquement conducteur et le circuit intégré apparaît comme un point crucial pour la réalisation des puces.

Il apparaît également que des contraintes importantes existent sur les dimensions de la puce et notamment sur les dimensions des rainures afin de pouvoir encastrer facilement et de manière pérenne les fils électriquement conducteurs.

Le brevet US 7723854 propose de réaliser une connexion électrique en utilisant des phénomènes de capillarité. Deux billes métalliques sont formées sur un substrat et un objet est placé entre les deux billes, les deux billes étant en contact avec l'objet. Dans une variante de réalisation, les deux billes sont placées de part et d'autre de l'objet et à l'extrémité de l'objet. L'ensemble est alors posé sur le substrat de sorte que les billes viennent en contact du substrat.

Un recuit est réalisé de manière à faire fondre les billes métalliques et solidariser l'objet avec le substrat.

Le document EP 2339618 divulgue un procédé d'assemblage d'un élément filaire avec une puce microélectronique. Deux éléments de la puce microélectronique sont reliés par un élément plastiquement déformable pour former une rainure qui contient l'élément filaire. L'élément plastiquement déformable est serré entre les deux éléments jusqu'à obtenir la fixation de l'élément filaire dans la rainure.

### Objet de l'invention

L'invention a comme objet de fournir un procédé de fabrication d'un dispositif électronique qui est facile à mettre en œuvre et qui permet de réaliser un dispositif plus performant.

Le procédé de fabrication selon l'invention est défini dans la revendication 1. Ce procédé de fabrication comporte :
- fournir un premier empilement comportant :
   ∘ un premier substrat comportant au moins une surface principale munie d'au moins une première zone de contact électrique,
   ∘ un deuxième substrat muni d'une entretoise saillante,
- assembler le premier substrat avec le deuxième substrat de manière à définir au moins une première rainure latérale comportant la première zone de contact électrique, la première rainure latérale étant délimitée par le premier substrat, le deuxième substrat et l'entretoise.

Le procédé est remarquable en ce que, lors de l'assemblage du deuxième substrat avec le premier substrat, le premier substrat comporte au moins une première protubérance agencée pour former une butée et limiter le déplacement de l'entretoise par rapport au premier substrat selon au moins une première direction passant par la première rainure latérale et l'entretoise et une deuxième direction parallèle à l'axe longitudinal de la première rainure et perpendiculaire à la première direction.

Dans un développement, lors de l'assemblage du deuxième substrat avec le premier substrat, le premier substrat comporte, en outre, une deuxième zone de contact électrique sur ladite au moins une surface principale, la première zone de contact électrique étant distincte de la deuxième zone de contact électrique, le deuxième substrat étant configuré pour définir avec le premier substrat au moins une deuxième rainure latérale comportant la deuxième zone de contact électrique, la deuxième rainure latérale étant séparée de la première rainure latérale par l'entretoise.

De manière avantageuse, l'entretoise est fixée au deuxième substrat avant l'assemblage du deuxième substrat avec le premier substrat.

Selon l'invention, le procédé comporte une étape additionnelle de fixation du deuxième substrat avec le premier substrat après l'assemblage du deuxième substrat avec le premier substrat.

Avantageusement, l'étape additionnelle de fixation est réalisée par collage, fusion d'un matériau fusible, scellement moléculaire ou scellement anodique de l'entretoise avec le premier substrat

Préférentiellement, l'étape additionnelle de fixation est réalisée en appliquant une contrainte en pression entre le premier substrat et le deuxième substrat.

Il est intéressant de prévoir que l'étape additionnelle de fixation soit réalisée au moyen d'un traitement thermique

Dans un mode de réalisation avantageux, ladite au moins une première protubérance est électriquement conductrice et connectée à la première zone de contact électrique, la au moins une première protubérance étant configurée pour bloquer le déplacement de l'entretoise au moins selon la première direction.

Dans un développement, au moins la première protubérance définit au moins une butée selon la première direction et l'entretoise comporte une première paroi latérale définissant une première zone en saillie selon la première direction, la butée coopérant avec la première zone en saillie pour bloquer le déplacement de l'entretoise selon la deuxième direction .

Dans un mode de réalisation particulier, le premier substrat comporte au moins une deuxième protubérance électriquement conductrice et connectée à la deuxième zone de contact électrique, la deuxième protubérance étant configurée pour bloquer le déplacement de l'entretoise au moins selon la première direction.

Il est intéressant de prévoir que la deuxième protubérance définisse au moins une butée selon la première direction et que l'entretoise comporte une deuxième paroi latérale opposée à la première paroi latérale et définissant une deuxième zone en saillie selon la première direction, la deuxième protubérance coopérant avec la deuxième zone en saillie pour bloquer le déplacement de l'entretoise selon la deuxième direction, les première et deuxième protubérances bloquant l'entretoise selon la première direction et selon la deuxième direction dans deux sens opposés.

Préférentiellement, l'entretoise comporte au moins une première portion et une deuxième portion, la première portion ayant une largeur inférieure à la deuxième portion, la largeur étant définie selon la première direction, les première et deuxième portions étant disposées consécutivement selon la deuxième direction pour définir la première zone en saillie.

De manière avantageuse, l'entretoise comporte au moins une troisième portion ayant une largeur supérieure à la largeur de la première portion, la troisième portion étant séparée de la deuxième portion par la première portion pour définir la deuxième zone en saillie.

Dans un autre développement, les première et deuxième zones en saillie sont séparées par la première portion de l'entretoise.

Préférentiellement, ladite au moins première protubérance est réalisée dans un matériau de brasure.

Selon l'invention, le procédé comporte, postérieurement à la fixation du premier substrat avec le deuxième substrat, une étape de recuit configurée pour éliminer au moins partiellement la butée de la première protubérance.

Dans un mode de réalisation préférentiel, le procédé de fabrication comporte l'introduction d'au moins un premier fil électriquement conducteur dans la première rainure latérale l' étape de recuit transformant le matériau de brasure formant la première protubérance en un matériau liquide qui recouvre au moins partiellement le premier fil électriquement conducteur par capillarité.

Un dispositif électronique fabriqué selon le procédé de l'invention possède une meilleure tenue dans le temps que les dispositifs de l'art antérieur.

Le dispositif électronique comporte :
- un premier substrat comportant au moins une surface principale munie d'au moins une première zone de contact électrique,
- un deuxième substrat comportant une entretoise, l'entretoise séparant le premier substrat et le deuxième substrat pour définir au moins une première rainure latérale comportant la première zone de contact électrique.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en coupe, un premier mode de réalisation d'une puce à circuit intégré,
- les figures 2, 3 et 4, représentent de manière schématique, en vue de dessus, trois variantes de réalisation d'une entretoise posée sur un premier substrat et séparant deux éléments filaires,
- la figure 5 représente, de manière schématique, en coupe, un second mode de réalisation d'une puce à circuit intégré,
- la figure 6 représente, de manière schématique, en vue de dessus, une autre variante de réalisation d'une entretoise posée sur un premier substrat et séparant deux éléments filaires.

### Description détaillée

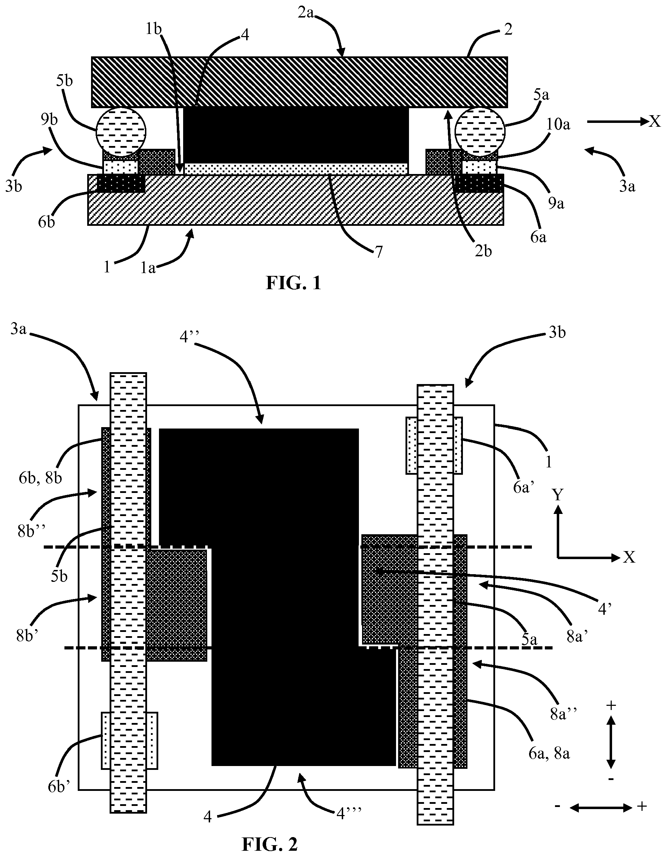

Comme illustré à la figure 1, le dispositif électronique est une puce ou puce à circuit intégré qui comporte un premier substrat 1 et un deuxième substrat 2 qui sont séparés par une entretoise 4. La puce comporte deux faces principales externes opposées 1a et 2a. La première face principale externe 1a est formée par une première face du premier substrat 1. La deuxième face principale externe 2a est formée par une première face du deuxième substrat 2. De préférence, les deux faces principales externes opposées 1a et 2a sont parallèles. De préférence, la puce comporte deux faces principales 1a et 2a reliées l'une à l'autre par des faces latérales. Au moins une rainure 3a/3b est présente dans l'une des faces latérales. Dans le mode de réalisation illustré, deux rainures 3a et 3b sont formées. Dans le mode de réalisation illustré, les deux rainures latérales 3a et 3b sont séparées par une entretoise 4.

Dans les modes de réalisation illustrés aux figures 1 à 6, la forme générale de la puce est parallélépipédique, les deux faces principales externes peuvent alors être de dimensions sensiblement égales, et sont reliées par quatre faces latérales. Bien entendu d'autres formes de puces sont possibles. On pourra, par exemple, avoir un premier substrat 1 et/ou un deuxième substrat 2 présentant une face principale externe bombée. En outre, une face latérale peut être le prolongement d'une face principale, sans arêtes de délimitation précise entre celles-ci.

La puce est formée en fournissant un premier substrat 1 puis en lui associant un deuxième substrat 2 qui comporte une entretoise 4 saillante. L'entretoise 4 sépare le premier substrat 1 et le deuxième substrat 2. Dans un premier mode de réalisation, l'entretoise 4 a été solidarisée avec le deuxième substrat 2, par exemple par collage. Dans un mode de réalisation alternatif, l'entretoise 4 est formée dans le deuxième substrat 2 par gravure du deuxième substrat 2. Il est également possible de combiner ces deux modes de réalisation.

Dans un premier mode de réalisation, l'entretoise 4 est mise en contact avec le premier substrat 1 puis une étape de fixation est avantageusement réalisée afin de fixer l'entretoise 4 sur le premier substrat 1. L'étape de fixation peut être réalisée entre appliquant une pression entre le premier substrat 1 et le deuxième substrat 2 et avantageusement un recuit. Dans un mode de réalisation particulièrement avantageux, la fixation de l'entretoise 4 avec le premier substrat 1 se fait par collage. De manière préférentielle, l'étape de fixation est effectuée par collage, fusion d'un matériau fusible, scellement moléculaire ou scellement anodique de l'entretoise 4 avec le premier substrat 1.

De manière préférentielle, l'étape de fixation est réalisée au moyen d'un recuit. Dans un mode de réalisation particulier, la fixation est réalisée au moyen d'un recuit dont la température maximale est comprise entre la température de transition vitreuse et la température de polymérisation de la colle utilisée pour coller l'entretoise 4 avec le premier substrat 1. A titre d'exemple, la colle est une colle commercialisée sous le nom HT1010 par la société Brewer Science Inc.

Ensuite, des éléments filaires 5a, 5b sont insérés longitudinalement respectivement dans les rainures 3a, 3b. Les éléments filaires 5a, 5b sont, de préférence, pincés mécaniquement dans les rainures 3a, 3b.

En alternative, les éléments filaires 5a, 5b sont placés dans la puce avant l'étape de fixation.

Le premier substrat 1 comporte au moins un bloc fonctionnel configuré pour réaliser au moins une fonction logique et/ou analogique et éventuellement mécanique (cf support de fils électriques...). Le premier substrat 1 comporte également au moins une première zone de contact électrique 6a. Dans le mode de réalisation illustré, le premier substrat 1 comporte une deuxième zone de contact électrique 6b. De manière avantageuse, le premier substrat 1 comporte un substrat en silicium ou est constitué par un substrat en silicium. Dans un mode de réalisation particulier, le premier circuit intégré est configuré pour réaliser une fonction de type Radio-identification également appelé « radio frequency identification » ou RFID. De manière avantageuse, le bloc fonctionnel est un circuit intégré configuré pour réaliser au moins une fonction logique et/ou analogique. Il est également possible que le bloc fonctionnel assure une fonction mécanique et avantageusement le support des fils électriques.

La première zone de contact électrique 6a est distincte de la deuxième zone de contact électrique 6b et ces deux zones sont séparées par une première distance. Les deux zones de contact électrique 6a et 6b sont connectées électriquement au circuit intégré formé dans le premier substrat 1. Si une seule rainure latérale 3a est définie, une seule zone de contact électrique 6a peut être formée et connectée au circuit intégré.

Les au moins deux zones de contact électrique 6a et 6b sont formées sur une deuxième face 1b du premier substrat 1 qui est opposée à la première face 1a du premier substrat 1. La deuxième face 1b du premier substrat 1 se trouve en vis-à-vis direct avec la deuxième face 2b du deuxième substrat 2. Les faces 1b et 2b sont appelées faces principales internes voire faces principales.

La deuxième face 1b du premier substrat 1 est réalisée dans un matériau électriquement isolant ou semi-isolant et avantageusement dans un matériau barrière aux polluants extérieurs, par exemple l'eau. Les deux zones de contact électrique 6a et 6b sont formées à l'intérieur de la couche isolante et barrière. De manière classique, les zones de contact électrique 6a et 6b présentent une surface restreinte car elles doivent s'intégrer dans le premier substrat 1 sans gêner le transit des signaux dans les différents niveaux d'interconnexion. Il est possible d'utiliser du silicium comme matériau semi-isolant.

Les deux zones de contact électrique 6a et 6b sont formées sur une zone périphérique du premier substrat 1 de manière à être situées à l'intérieur des deux rainures latérales 3a et 3b de la puce. En variante, plus de deux zones de contact électrique sont présentes avec par exemple des zones additionnelles de contact 6a' et 6b'.

L'entretoise 4 et le deuxième substrat 2 sont solidarisés avec le premier substrat 1 pour définir les rainures latérales 3a et 3b. La rainure latérale 3a est définie au moyen du premier substrat 1, du deuxième substrat 2 et de l'entretoise 4. Il peut en être de même pour la deuxième rainure 3b.

Dans un mode de réalisation avantageux, le premier substrat 1 et le deuxième substrat 2 sont configurés pour réaliser une pluralité de puces. Le premier substrat 1 comporte une pluralité de circuits intégrés identiques ou différents qui se répètent avantageusement selon un premier pas de répétition dans la première direction X et qui se répètent avantageusement selon un deuxième pas de répétition dans la deuxième direction Y.

Le deuxième substrat 2 est placé sur le premier substrat 1 de manière à former la pluralité de puces qui comportent des rainures latérales. Une fois les deux substrats mis en contact et fixés l'un à l'autre, une étape de découpe peut être réalisée de manière à découper le premier substrat 1, le deuxième substrat 2 et éventuellement l'entretoise 4 et ainsi définir une pluralité de puces. Les puces peuvent alors être dissociées les unes des autres.

Dans un premier cas de figure, le premier substrat 1 comporte des lignes de fragilisation prédéfinie afin de définir les dimensions des différentes puces et faciliter la découpe à venir. Il en est de même pour le deuxième substrat 2. Il est alors particulièrement avantageux de bien aligner le premier substrat 1 avec l'ensemble formé par l'entretoise 4 et le deuxième substrat 2 afin d'aligner les lignes de fragilisation prédéfinie et faciliter la découpe des puces.

L'entretoise 4 présente une largeur inférieure à la largeur du premier substrat 1 et à la largeur du deuxième substrat 2 de manière à définir deux rainures latérales ou au moins une rainure latérale. Il est particulièrement avantageux de prévoir que la longueur de l'entretoise 4 est inférieure à la première longueur du premier substrat 1 et à la deuxième longueur du deuxième substrat 2 ce qui facilite le découpage des puces. Le deuxième substrat 2 comporte alors une pluralité d'entretoises 4 distinctes. La découpe du deuxième substrat 2 se fait préférentiellement dans les zones dépourvues d'entretoise 4.

Dans un deuxième cas de figure, le premier substrat 1 et/ou le deuxième substrat 2 sont dépourvus de lignes de fragilisation prédéfinie. Les puces sont découpées par toute technique adaptée, par exemple au moyen d'une scie ou d'un rayonnement laser. Dans ce cas de figure, le premier substrat 1 et le deuxième substrat 2 présentent des dimensions identiques selon la première direction et selon la deuxième direction.

Comme indiqué plus haut, il est nécessaire de maîtriser l'alignement du premier substrat 1 par rapport à l'entretoise 4 et au deuxième substrat 2. Cet alignement doit être maîtrisé lors de la mise en contact avec le premier substrat 1 et il doit également être maîtrisé lors de la phase de fixation du premier substrat 1 avec l'entretoise 4.

Selon les modes de réalisation, l'entretoise 4 et le deuxième substrat 2 sont réalisés dans des matériaux différents ou l'entretoise 4 et le deuxième substrat 2 sont réalisés dans les mêmes matériaux. De manière avantageuse, le deuxième substrat 2 peut comporter ou être constitué par un substrat en silicium. En alternative, le deuxième substrat 2 peut être réalisé dans un matériau électriquement isolant ou électriquement conducteur qui est recouvert par une couche électriquement isolante.

Dans un mode de réalisation, le deuxième substrat 2 est un élément actif, c'est-à-dire qu'il comporte un composant électronique, par exemple une batterie. Le deuxième substrat 2 peut être configuré pour alimenter le premier substrat 1. En alternative, le deuxième substrat 2 est dépourvu de composant électronique.

Dans un mode de réalisation, l'entretoise 4 et le deuxième substrat 2 sont formés séparément et sont assemblés par la suite. L'entretoise 4 peut être fixée sur le deuxième substrat 2 par tout moyen connu. Dans une variante de réalisation, l'entretoise 4 est formée dans le deuxième substrat 2 par gravure. Il est avantageux de réaliser le deuxième substrat 2 et l'entretoise 4 dans un substrat en silicium qui a subi une étape de gravure profonde afin de définir l'entretoise 4 ou plusieurs entretoises.

L'entretoise 4 sépare le premier substrat 1 et le deuxième substrat 2 et définit, avec ces derniers, une première rainure latérale 3a et avantageusement une deuxième rainure latérale 3b. Chaque rainure latérale comporte deux faces opposées formées respectivement par le premier substrat 1 et le deuxième substrat 2 et un fond formé par l'entretoise 4. Ainsi, les deux rainures latérales 3a/3b sont séparées par l'entretoise 4. Chaque rainure 3a/3b est ouverte à ses deux extrémités.

La première rainure latérale 3a possède, sur sa première face latérale, la première zone de contact électrique 6a. La deuxième rainure latérale possède, sur sa première face latérale, la deuxième zone de contact électrique 6b.

Dans un mode de réalisation particulier, la première rainure latérale 3a et/ou la deuxième rainure latérale 3b possèdent une zone de contact électrique additionnelle 6a'/6b'. Cette zone de contact électrique additionnelle permet d'émettre et/ou recevoir des signaux différents de la première ou deuxième zone de contact électrique présente dans la rainure 3a/3b.

La puce possède ou est destinée à recevoir des premier et deuxième fils électriquement conducteurs 5a/5b également appelés premier et deuxième éléments filaires. Les premier et deuxième fils électriquement conducteurs 5a/5b sont destinés à venir en contact électrique avec respectivement la première zone de contact électrique 6a et la deuxième zone de contact électrique 6b et éventuellement les zones 6a' et 6b'.

Chaque élément filaire 5a/5b présente un axe longitudinal qui est parallèle ou sensiblement parallèle à l'axe longitudinal de la rainure 3a/3b, c'est-à-dire parallèle à l'axe Y. Chaque élément filaire 5a/5b est solidarisé au premier substrat 1 par soudure avec apport de matériau, par collage, et/ou par encastrement. L'encastrement dans la rainure 3a/3b nécessite de dimensionner correctement l'élément filaire 5a/5b et la rainure 3a/3b. La tenue mécanique par encastrement peut être insuffisante et nécessite en général une phase de renforcement par l'apport de colle et/ou de métal.

La section des fils électriquement conducteurs 5a/5b peut être quelconque. Selon les modes de réalisation, les premier et deuxième fils électriquement conducteurs 5a/5b sont des fils conducteurs monobrins ou multibrins. Il est donc possible d'avoir une puce comportant deux fils conducteurs monobrins ou deux fils conducteurs multibrins ou encore un mélange de ces deux technologies. Un fil conducteur multibrins comporte plusieurs fils conducteurs qui sont électriquement dissociés et qui permettent de faire passer des signaux différents. En alternative, le fil conducteur multibrins comporte plusieurs fils conducteurs qui sont connectés ensemble électriquement et qui font circuler le même signal électrique. Un fil conducteur multibrins peut par exemple se présenter sous la forme d'un toron de plusieurs fils électriquement conducteurs. Il est particulièrement avantageux d'utiliser un fil conducteur multibrins en association avec une colle car le matériau de collage utilisé pour solidariser le fil électriquement conducteur avec le premier substrat 1 s'imprègne dans les interstices des fils ce qui améliore la qualité du collage. La colle peut être quelconque. Elle est par exemple formée par un matériau de brasure.

Lorsque la puce est une puce de type RFID, le premier et/ou le deuxième fils électriquement conducteurs 5a/5b sont avantageusement configurés pour former des antennes de communication.

Les premier et deuxième fils électriquement conducteurs 5a/5b sont avantageusement configurés pour être encastrés dans la première rainure 3a et dans la deuxième rainure 3b, c'est-à-dire que le premier substrat 1 et le deuxième substrat 2 appuient tous les deux sur les fils électriquement conducteurs 5a/5b afin que ces derniers restent à l'intérieur des rainures latérales. De cette manière, les risques de désolidarisation des fils électriquement conducteurs 5a/5b avec la puce sont réduits. Les premier et deuxième fils électriquement conducteurs 5a/5b peuvent être en compression au moyen des premier et deuxième substrats 1 et 2. En alternative, les premier et deuxième fils électriquement conducteurs 5a/5b ne sont pas contraints par les premier et deuxième substrats 1 et 2.

La hauteur de l'entretoise 4 et la section des fils électriquement conducteurs 5a/5b sont avantageusement configurées pour assurer la compression des fils électriquement conducteurs entre les deux substrats.

De manière avantageuse, une couche de fixation 7 est placée entre l'entretoise 4 et le premier substrat 1 de manière à fixer l'entretoise 4 avec le premier substrat 1. La couche de fixation 7 peut être placée sur le premier substrat 1 et/ou sur l'entretoise 4. De manière générale, la fixation de l'entretoise 4 avec le premier substrat 1 est réalisée par toute technique connue, par exemple par collage, par brasure, par soudure.

Le premier substrat 1 peut être de forme quelconque. Cependant, il est avantageux de prévoir un premier substrat 1 qui présente une section carrée ou rectangulaire. Le premier substrat 1 présente une première largeur mesurée selon une première direction X et une première longueur mesurée selon une deuxième direction Y. La première direction X est perpendiculaire à la deuxième direction Y.

Le deuxième substrat 2 peut être de forme quelconque. Là encore, il est avantageux de prévoir un deuxième substrat 2 qui présente une section carrée ou rectangulaire. Le deuxième substrat 2 présente une deuxième largeur mesurée selon la première direction X et une deuxième longueur mesurée selon la deuxième direction Y.

Dans un mode de réalisation préférentiel, la première longueur est égale à la deuxième longueur et/ou la première largeur est égale à la deuxième largeur.

Il est particulièrement avantageux de prévoir que la forme du premier substrat 1 est identique à la forme du deuxième substrat 2 ce qui rend la puce plus robuste lors de son utilisation, notamment en réduisant le risque de désolidarisation entre le premier substrat 1 et le deuxième substrat 2.

Pour être intégrées dans de très nombreuses applications, les puces présentent des dimensions réduites ce qui complique leur procédé de fabrication en augmentant la criticité des contraintes d'alignement entre le premier substrat 1 et l'ensemble formé par l'entretoise 4 et le deuxième substrat 2.

Comme indiqué précédemment, l'ensemble formé par l'entretoise 4 et le deuxième substrat 2 est configuré pour définir une ou deux rainures latérales avec le premier substrat 1.

Il existe donc une première contrainte selon la première direction X afin que les deux rainures latérales présentent des dimensions suffisantes pour accepter et maintenir chacun des deux fils électriquement conducteurs 5a/5b.

Par définition, l'entretoise 4 étant moins large que le second substrat 2, il n'est pas possible de voir la position exacte de l'entretoise 4 lors de son placement. Il est également compliqué d'estimer la position de l'entretoise 4 par rapport à la position du second substrat 2 car leurs positions respectives peuvent évoluer selon les aléas des procédés de fabrication (collage de l'entretoise 4 sur le second substrat 2, gravure de l'entretoise 4 dans le second substrat 2...).

Les inventeurs ont observé que les contraintes d'alignement sont présentes selon la première direction X. Cette contrainte selon la première direction X permet de centrer l'entretoise 4 par rapport aux deux zones de contact électrique du premier substrat 1 qui sont situées de part et d'autre de l'entretoise 4 après l'étape d'assemblage.

Lors du procédé de fabrication de la puce, l'ensemble formé par l'entretoise 4 et le deuxième substrat 2 est mis en contact avec le premier substrat 1. Un premier alignement est réalisé selon les directions X et Y de manière à placer judicieusement l'entretoise 4 par rapport au premier substrat 1 et ainsi définir les deux rainures latérales et s'assurer que le premier substrat 1 est bien en vis-à-vis avec le deuxième substrat 2. Ce placement de l'entretoise 4 par rapport au premier substrat 1 est appelé étape d'assemblage.

L'étape d'assemblage permet de définir au moins la première rainure latérale 3a qui comporte la première zone de contact 6a.

A la suite de l'étape d'assemblage, une étape de fixation est réalisée de manière à fixer le premier substrat 1 avec l'entretoise 4 et donc le premier substrat 1 avec le deuxième substrat 2. Lors de la solidarisation des deux substrats, une contrainte en pression est appliquée sur le premier substrat 1 et sur le deuxième substrat 2 ce qui se traduit par un déplacement éventuel du premier substrat 1 par rapport au deuxième substrat 2 par glissement sur la surface 1b du premier substrat 1. Ce déplacement est lié, par exemple à la couche d'adhésif 7 qui se trouve entre le premier substrat 1 et l'entretoise 4. Juste avant l'adhésion, la couche 7 se transforme et généralement se liquéfie ce qui favorise le glissement entre l'entretoise 4 et le premier substrat 1. Lors du glissement, l'entretoise 4 se déplace ce qui se traduit par une modification des dimensions des rainures latérales. Le premier alignement est dégradé voire perdu.

Afin d'assurer un bon alignement lors de l'étape d'assemblage et d'éviter le déplacement de l'entretoise 4 lors de la fixation de l'entretoise 4 avec le premier substrat 1, des moyens de blocage sont placés sur le premier substrat 1. Les moyens de blocage sont avantageusement formés par au moins une première protubérance 8a en saillie par rapport à la deuxième surface 1b du premier substrat 1 de manière à venir en contact avec l'entretoise 4 et bloquer son déplacement selon la première direction X et selon la deuxième direction Y. De cette manière, le premier alignement réalisé lors de la mise en contact de l'entretoise 4 avec le premier substrat 1 est partiellement conservé lors de la solidarisation/fixation de l'entretoise 4 avec le premier substrat 1.

Il est particulièrement avantageux d'utiliser au moins une première protubérance 8a qui forme une butée qui vient limiter le déplacement de l'entretoise 4 selon la direction X et selon la direction Y. La forme de la première protubérance 8a peut être quelconque. De manière avantageuse, il est avantageux d'utiliser une pluralité de protubérances distinctes afin de former une pluralité de butées qui viennent limiter le déplacement de l'entretoise 4 selon les directions X et Y.

Cependant, il est également possible d'utiliser une seule protubérance qui est agencée pour limiter le déplacement de l'entretoise 4 selon les directions X et/ou Y. La protubérance peut par exemple faire le tour de la zone de contact mécanique entre l'entretoise 4 et le premier substrat 1. En alternative, la protubérance peut avoir la forme d'un C ou d'un L afin de limiter le déplacement de l'entretoise 4 selon les directions X et Y et selon un ou deux sens opposés de chaque direction.

La puce ayant de faibles dimensions, il est particulièrement avantageux d'utiliser des première et deuxième protubérances 8a et 8b qui sont respectivement connectées à la première zone de contact électrique 6a et la deuxième zone de contact électrique 6b et qui sont configurées pour limiter le déplacement de l'entretoise 4 selon la première direction X et selon la deuxième direction Y. Il est particulièrement avantageux de prévoir une protubérance électriquement conductrice formant au moins une partie de la zone de contact électrique.

Les première et deuxième protubérances 8a et 8b participent à la fixation des premier et deuxième fils électriquement conducteurs 5a et 5b contre le premier substrat 1 et à une amélioration de la connexion électrique entre le fil électriquement conducteur 5a/5b et la zone de contact.

De cette manière, la pluralité de protubérances formées sur le premier substrat 1 comporte au moins deux protubérances connectées électriquement au circuit intégré. La première protubérance 8a permet de bloquer le premier fil électriquement conducteur 5a dans la première rainure latérale 3a et de relier le premier fil électriquement conducteur 5a avec la première zone de contact électrique 6a. La deuxième protubérance 8b permet de bloquer le deuxième fil électriquement conducteur 5b dans la deuxième rainure latérale 3b et de relier le deuxième fil électriquement conducteur 5b avec la deuxième zone de contact électrique 6b.

Les première et deuxième protubérances 8a et 8b sont formées dans un matériau électriquement conducteur qui assure le contact électrique entre le fil électriquement conducteur 5a/5b et le circuit intégré.

De manière avantageuse, la première protubérance 8a et/ou la deuxième protubérance 8b comportent ou sont constituées d'un matériau de brasure qui est configuré pour fondre et recouvrir le fil électriquement conducteur 5a/5b par capillarité afin d'accroitre l'adhésion entre la puce et le fil électriquement conducteur 5a/5b.

Dans un mode de réalisation préférentiel, la première protubérance 8a est réalisée au moyen de plusieurs matériaux électriquement conducteurs. Dans le mode de réalisation illustré à la figure 1, des première et deuxième zones saillantes 9a et 10a sont superposées pour former la première protubérance 8a. Un premier matériau électriquement conducteur est recouvert par un deuxième matériau électriquement conducteur. Le premier matériau électriquement conducteur possède une température de fusion supérieure à la température de fusion du deuxième matériau électriquement conducteur d'une valeur avantageusement égale à 30°C. Le deuxième matériau électriquement conducteur est également appelé matériau de brasure. Dans un mode de réalisation particulier, la première protubérance 8a est formée par la zone 10a seulement. Il est également possible de prévoir que la première protubérance 8a et/ou la deuxième protubérance 8b sont formées exclusivement en matériau de brasure.

Dans un mode de réalisation, la première protubérance 8a et la deuxième protubérance 8b sont configurées pour bloquer le déplacement de l'entretoise 4 selon l'axe X dans un sens, c'est-à-dire que le désalignement est limité dans un seul sens par exemple le sens + ou le sens -. Dans un autre mode de réalisation, la première protubérance 8a et la deuxième protubérance 8b sont configurées pour bloquer le déplacement de l'entretoise 4 selon l'axe X dans les deux sens, c'est-à-dire que le désalignement est limité dans le sens + et le sens -. Les première et deuxième protubérances 8a et 8b sont placées respectivement dans la première rainure 3a et dans la deuxième rainure 3b.

Dans un mode de réalisation particulièrement avantageux, la première protubérance 8a déborde au-delà de la première zone de contact électrique 6a et la deuxième protubérance 8b déborde de la deuxième zone de contact électrique 6b. De manière préférentielle, le deuxième matériau électriquement conducteur 10a/10b est un matériau de brasure et déborde avantageusement au-delà du premier matériau électriquement conducteur formant la première zone saillante 9a/9b.

Chaque rainure latérale 3a/3b comporte avantageusement une protubérance qui fait saillie de la zone de contact électrique 6a/6b et permet de limiter le déplacement de l'entretoise 4 selon la première direction X . En cas de glissement, l'entretoise 4 vient en butée contre l'une des protubérances qui la bloque ce qui permet de conserver une rainure latérale 3a/3b ayant une profondeur minimale. La largeur de l'entretoise 4 permet de définir la profondeur maximale de l'autre rainure latérale.

La butée qui existe pour limiter le déplacement selon la direction Y permet d'assurer une surface de connexion minimale entre l'entretoise 4 et le premier substrat 1 et donc une certaine tenue au collage. Cela permet également de limiter un décalage entre les deux substrats ce qui peut fragiliser la puce en facilitant les appuis en flexion sur une extrémité d'un des substrats.

Lors de l'étape de fixation, l'entretoise 4 peut légèrement se décaler mais elle vient en butée contre les moyens de blocage selon la direction X et selon la direction Y ce qui évite une modification excessive des dimensions des rainures latérales tant d'un point de vue de sa largeur ou profondeur mesurée selon la direction X que d'un point de vue de sa longueur mesurée selon la direction Y.

Dans un mode de réalisation particulier illustré aux figures 2, 3 et 4, l'entretoise 4 comporte une première paroi latérale qui définit une première zone en saillie selon l'axe X, c'est-à-dire selon un axe passant successivement par le premier élément filaire 5a, l'entretoise 4 et le deuxième élément filaire 5b. La première protubérance 8a coopère avec la première zone en saillie pour bloquer le déplacement de l'entretoise 4 selon la deuxième direction Y et selon au moins un sens de déplacement. Le blocage est obtenu lorsque la première protubérance 8a arrive en contact de la zone en saillie de l'entretoise 4. Cette zone en saillie vient en butée sur une zone de la première protubérance qui est avantageusement formée exclusivement par le matériau de brasure.

Si la butée limitant le déplacement de l'entretoise 4 selon la direction Y est formée exclusivement en matériau de brasure, il est avantageux de réaliser la fixation de l'entretoise 4 avec le premier substrat 1 avant de recuire le matériau de brasure pour le transformer en un matériau liquide.

De manière avantageuse, l'entretoise 4 comporte une deuxième paroi latérale opposée à la première paroi latérale. Cette deuxième paroi latérale définit une deuxième zone en saillie selon l'axe X, c'est-à-dire un axe passant successivement par le premier élément filaire 5a, l'entretoise 4 et le deuxième élément filaire 5b. La deuxième protubérance 8b coopère avec la deuxième zone en saillie pour bloquer le déplacement de l'entretoise 4 selon la deuxième direction Y. De manière avantageuse, les deux protubérances coopèrent pour bloquer l'entretoise 4 selon deux sens opposés. De cette manière, lorsque l'entretoise 4 se déplace selon un premier sens, la première zone en saillie vient en butée contre la première protubérance 8a. Lorsque l'entretoise 4 se déplace selon un deuxième sens, la deuxième zone en saillie vient en butée contre la deuxième protubérance 8b. Cette deuxième zone en saillie vient en butée sur une zone de la deuxième protubérance qui est avantageusement formée exclusivement par le matériau de brasure.

Là encore, les positions de la première protubérance 8a, de la deuxième protubérance 8b, de la première zone en saillie et de la deuxième zone en saillie selon l'axe Y permettent de définir le désalignement maximal autorisé pour l'entretoise 4.

Dans un mode de réalisation particulier, l'entretoise 4 comporte au moins une première portion 4' et une deuxième portion 4" disposées consécutivement selon l'axe Y. La première portion 4' présente une largeur inférieure à la largeur de la deuxième portion 4". La largeur est définie selon l'axe X, c'est-à-dire selon un axe passant successivement par le premier élément filaire 5a, l'entretoise 4 et le deuxième élément filaire 5b. Les première et deuxième portions définissent avantageusement la première zone en saillie de l'entretoise.

Dans ce cas de figure, il est également avantageux de prévoir que l'entretoise 4 comporte une troisième portion 4"' qui est séparée de la deuxième portion 4" par la première portion 4' selon l'axe Y. La troisième portion 4"' possède une largeur supérieure à la largeur de la première portion 4'. Ce mode de réalisation est simple à mettre en œuvre. Les première, deuxième et troisième portions définissent avantageusement la première et la deuxième zones en saillie de l'entretoise.

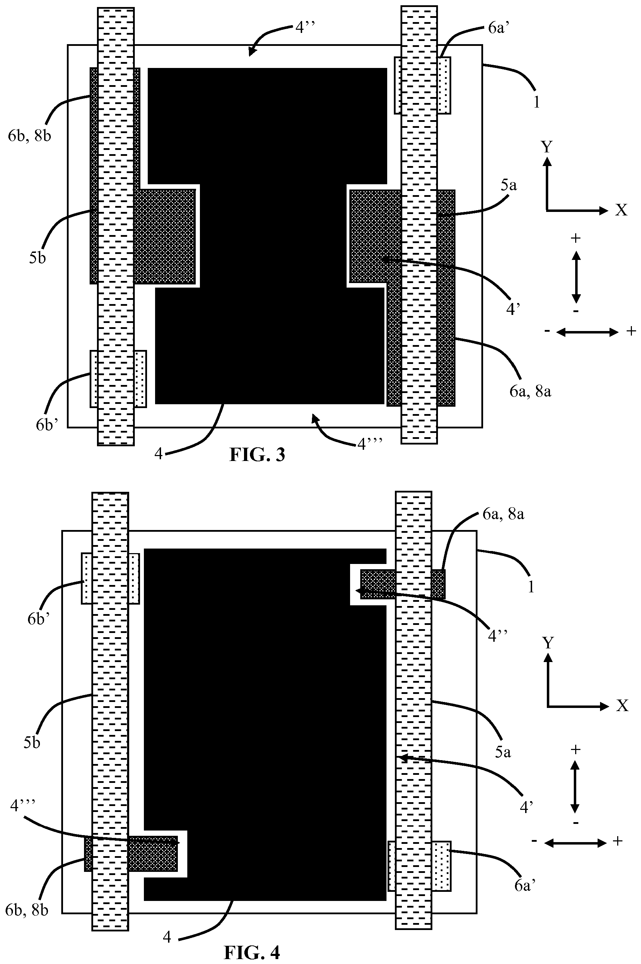

Dans le mode de réalisation illustré à la figure 2, une des parois latérales de la première portion 4' est dans le prolongement d'une des parois latérales de la deuxième portion 4" et l'autre paroi latérale de la première portion 4' est dans le prolongement de l'autre paroi latérale de la troisième portion 4"'. Ainsi chaque paroi latérale intervient pour bloquer le déplacement de l'entretoise 4 dans un seul sens. Ce mode de réalisation est particulièrement simple à mettre en œuvre. En alternative, il est également possible de prévoir qu'au moins une des parois latérales intervient pour bloquer le déplacement de l'entretoise 4 dans les deux sens opposés (+ et -) comme cela est illustré aux figures 3 et 4.

Dans un mode de réalisation particulier non représenté, l'entretoise 4 ne comporte pas de portion 4'.

Il est également avantageux de prévoir que la première protubérance 8a et la deuxième protubérance 8b sont en vis-à-vis de la première portion 4' de l'entretoise 4 selon la direction X pour bloquer l'entretoise 4 comme cela est illustré aux figures 2 et 3. Il est également avantageux de prévoir qu'un axe parallèle à la direction X passe par la première protubérance 8a, la première portion 4' de l'entretoise 4 et la deuxième protubérance 8b.

Dans un mode de réalisation particulier illustré à la figure 2, la première protubérance 8a possède une première portion 8a' et une deuxième portion 8a" consécutives selon l'axe Y. La première portion 8a' et la deuxième portion 8a" définissent une zone en saillie selon l'axe X sur la paroi latérale interne de la première protubérance 8a. La paroi latérale interne est la paroi latérale qui fait face à l'entretoise 4. Dans le mode de réalisation illustré à la figure 4, les deux protubérances sont décalées selon la direction Y.

Dans un autre mode de réalisation particulier, la deuxième protubérance 8b possède également une première portion 8b' et une deuxième portion 8b" consécutives selon l'axe Y. La première portion 8b' et la deuxième portion 8b" définissent une zone en saillie selon l'axe X sur la paroi latérale interne de la deuxième protubérance 8b. La paroi latérale interne est la paroi latérale qui fait face à l'entretoise 4. Ce mode de réalisation est simple à mettre en œuvre.

La première portion 8a' de la première protubérance définit une zone en saillie qui s'étend en direction du centre de la puce, c'est-à-dire en direction de l'entretoise 4 lorsque l'on se déplace depuis une extrémité de puce vers le centre de la puce selon la direction X. En corollaire, la portion en saillie de l'entretoise 4 s'étend en direction de la première protubérance 8a" en sens opposé afin de bloquer le glissement de l'entretoise 4. Il peut en être de même pour la deuxième protubérance 8b.

Il est avantageux de prévoir que la première portion 8a' de la première protubérance 8a et la première portion 8b' de la deuxième protubérance 8b font face à la première portion 4' de l'entretoise 4 selon l'axe X. Ce mode de réalisation est particulièrement avantageux car il empêche un déplacement selon l'axe X, un déplacement selon l'axe Y et la rotation de l'entretoise 4 par rapport au premier substrat 1.

Il est avantageux de prévoir que l'entretoise 4 comporte au moins deux portions différentes qui définissent au moins une zone en saillie et de préférence au moins deux zones en saillie. Dans les modes de réalisation illustrés aux figures 2, 3 et 4, l'entretoise 4 comporte au moins trois portions distinctes définissant deux zones en saillie ou plus de deux zones en saillie.

Il est particulièrement avantageux de prévoir que la première portion 8a'/8b' de la première protubérance 8a et/ou de la deuxième protubérance 8b possèdent des largeurs plus importantes que les deuxièmes portions 8a"/8b" respectives de la protubérance lorsque les protubérances sont réalisées en matériau de brasure. Cette largeur plus importante correspond à une quantité de matière plus importante ce qui permet de réduire les risques de déplétion en matériau de brasure. De manière avantageuse, les portions 8a' et 8b' sont exclusivement réalisées en matériau de brasure.

Il apparait évident que la largeur de l'entretoise 4 et la largeur des protubérances 8a et 8b ne peuvent être choisies de sorte que l'entretoise 4 s'aligne sans jeu par rapport aux protubérances du premier substrat 1 car cela entraine des contraintes excessives vis-à-vis de l'alignement initial du premier substrat 1 avec l'entretoise 4.

Les inventeurs ont observé qu'un espacement, avantageusement compris dans la gamme 5 microns à 10 microns, entre l'entretoise 4 et chacune des première et deuxième protubérances 8a et 8b permet de faciliter l'alignement et le maintien de l'alignement dans le temps.

Comme indiqué plus haut, la première protubérance 8a et/ou la deuxième protubérance 8b peuvent comporter des matériaux de brasure électriquement conducteurs. Lorsque les fils électriquement conducteurs 5a/5b sont insérés à chaud dans les rainures latérales 3a/3b de la puce, le matériau de brasure se liquéfie. Le matériau de brasure étant à l'état liquide, il mouille le fil électriquement conducteur 5a/5b par capillarité ce qui permet d'augmenter la surface de contact entre la zone 8a/8b et le fil électriquement conducteur 5a/5b. Par ailleurs, en utilisant une protubérance 8a/8b continue avec plusieurs portions ayant des largeurs différentes au lieu de plusieurs protubérances dissociées physiquement, le contact électrique et mécanique entre le fil électriquement conducteur 5a/5b et la zone de contact électrique 6a/6b est amélioré. Les risques de déplétion en matériau de brasure à proximité immédiate de la zone de contact électrique 6a/6b sont fortement réduits.

En alternative, le recuit de transformation du matériau de brasure peut être postérieur à l'introduction des fils électriquement conducteurs dans les rainures latérales.

Après l'étape de recuit du matériau de brasure et son pompage par capillarité pour fixer le fil électriquement conducteur, il peut rester quelques traces de la forme initiale de la protubérance.

Il est particulièrement avantageux de prévoir un matériau de brasure qui présente une température de fusion supérieure à la température utilisée lors de l'étape de fixation de l'entretoise avec le premier substrat.

Ce mode de réalisation est particulièrement avantageux, car après le recuit utilisé pour insérer les fils électriquement conducteurs 5a/5b, les première et deuxième protubérances 8a/8b utilisées pour bloquer le déplacement de l'entretoise 4 ont disparu et se sont transformées en des premier et deuxième films électriquement conducteurs qui recouvrent respectivement les premier et deuxième fils électriquement conducteurs 5a/5b.

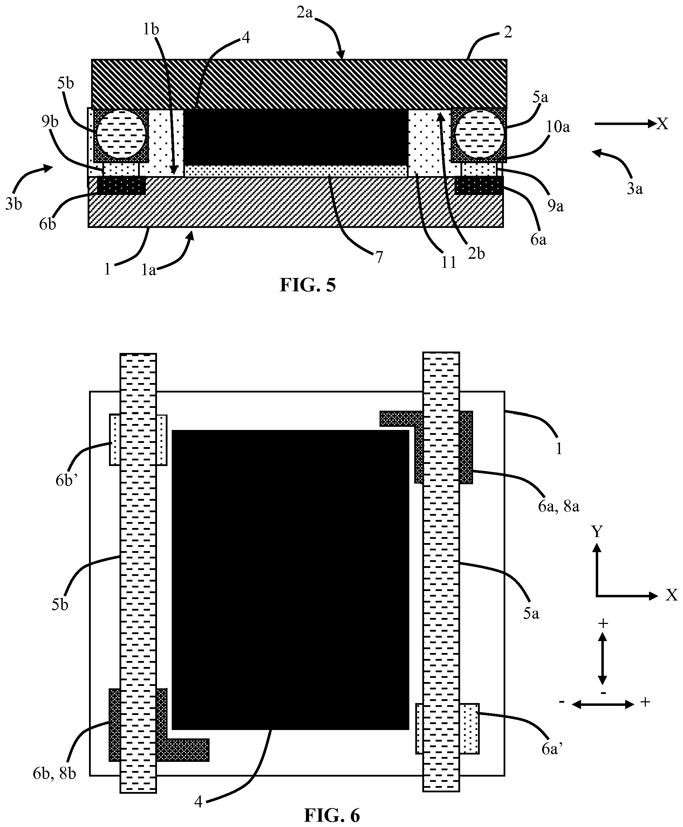

Comme illustré à la figure 5, le volume occupé initialement par une partie de la première protubérance 8a ou de la deuxième protubérance 8b est laissé libre. Ce nouvel espace libre peut être rempli par la suite par un matériau d'encapsulation 11 par exemple un adhésif qui va renforcer l'adhésion entre le premier substrat 1 et le deuxième substrat 2 ainsi qu'avec l'entretoise 4 et les fils électriquement conducteurs 5a/5b. De manière avantageuse, le matériau d'encapsulation 11 est configuré pour remplir les zones vides ce qui permet de renforcer la solidité de la puce. Dans un mode de réalisation particulier, le matériau d'encapsulation 11 est une colle et avantageusement une colle structurale qui peut être une colle E505 commercialisée par la société EPO-TEK. Il est également possible d'utiliser du Parylène également appelé poly(p-xylylène) ou un verre fusible.

En variante, le matériau d'encapsulation 11 peut être un matériau barrière qui est configuré pour bloquer le passage des polluants, par exemple l'eau. Dans un mode de réalisation particulier, le matériau d'encapsulation 11 est une colle et avantageusement une colle de protection qui peut être une colle TC420 commercialisée par la société POLYTEC Il est encore possible d'utiliser un matériau d'encapsulation 11 qui possède les deux fonctions: adhésive et barrière. Il est possible d'utiliser une colle TC420 commercialisée par la société POLYTEC.

Ce mode de réalisation est plus avantageux que celui où les zones de butée ne sont pas dans un matériau de brasure. En effet, dans ce dernier mode de réalisation, l'espace entre le fil électriquement conducteur et l'entretoise 4 peut être faible ce qui complique fortement les étapes de nettoyage. Par ailleurs, il est plus difficile d'introduire un matériau d'encapsulation 11 ce qui rend la puce plus sensible aux agressions extérieures mécaniques et/ou chimiques.

Par ailleurs, en utilisant des première et deuxième protubérances 8a/8b qui sont formées sur le premier substrat 1, il est possible d'utiliser des puces plus variées et de rajouter les protubérances 8a/8b a posteriori. Il est alors possible d'utiliser des puces ayant des zones de contact 6a/6b placées à différents endroits dans la rainure 3a/3b et de former par la suite les protubérances 8a et 8b afin d'adapter la puce pour l'entretoise 4 et le deuxième substrat 2. Il est possible d'adapter la forme des protubérances et la forme des entretoises au type de puce, c'est-à-dire au moins à la forme du premier substrat et à la position des contacts électrique sur la face principale. Dans un autre mode de réalisation, les premières portions 8a' et 8b' des protubérances sont décalées vers la périphérie du premier substrat et non au centre de la puce selon la direction Y. Ce décalage permet par exemple de former des protubérances en forme de L, par exemple sur au moins deux coins opposés du premier substrat. Ces deux protubérances forment des butées qui limitent le déplacement de l'entretoise 4 selon les directions X et Y. Ce mode de réalisation est avantageux car il permet d'utiliser une entretoise avec une section plus simple à réaliser dans le plan qui contient les directions X et Y. A titre d'exemple, l'entretoise à une section rectangulaire, mais une section carrée peut également être utilisée. L'entretoise peut être dépourvue de zone en saillie selon les directions X et/ou Y tout en étant bloquée par les protubérances.

Le même deuxième substrat peut être utilisé sur deux premiers substrats consécutifs qui possèdent des circuits intégrés différents sous réserve que les dimensions des puces soient identiques. La forme des première et deuxième protubérances permettra d'adapter le premier substrat au deuxième substrat.

Le placement du deuxième substrat 2 sur le premier substrat 1 avec le niveau d'alignement recherché peut être obtenu de manière industrielle au moyen d'équipements de collage et d'alignement commercialisés par les sociétés Suss MicroTec et EVG.

Dans un mode de réalisation particulier, l'entretoise 4 est formée à l'intérieur du deuxième substrat 2 par gravure ionique et préférentiellement par une gravure ionique de type Reactive Ion Etching et plus préférentiellement par Deep Reactive Ion Etching.

Le substrat est gravé de manière à former une entretoise 4 qui présente une hauteur comprise entre 100 microns et 200 microns. La hauteur de l'entretoise 4 correspond à la hauteur de la partie en saillie par rapport au reste du second substrat. La hauteur de l'entretoise 4 est définie en fonction du diamètre des fils électriquement conducteurs 5a/5b.

De manière avantageuse, la longueur de l'entretoise 4 est de l'ordre de quelques centaines de microns, par exemple entre 100 microns et 1 millimètre. La largeur de l'entretoise 4 est avantageusement de l'ordre de quelques dizaines de microns, par exemple entre 10 microns et 100 microns.

Selon les modes de réalisation, les protubérances 8a/8b formées sur le premier substrat 1 sont réalisées par croissance électrolytique ou par sérigraphie. D'autres techniques sont également disponibles mais moins pratiques d'un point de vue industriel. Il est possible de prévoir qu'une partie des protubérances est formée par croissance électrolytique et une autre partie des protubérances est formée par une autre technique par exemple par sérigraphie.

De manière avantageuse, les protubérances 8a/8b font saillie de la surface 1b du premier substrat 1 d'une hauteur comprise entre quelques microns et quelques centaines de microns. Par exemple, la hauteur des protubérances est comprise entre 2 microns et 500 microns.

La largeur de la protubérance 8a/8b est avantageusement de l'ordre de quelques dizaines de microns, par exemple entre 10 microns et 100 microns.

Les puces telles que décrites peuvent être intégrées dans des vêtements pour former des tissus intelligents de par leur petite taille.

## Revendications

1. Procédé de fabrication d'un dispositif électronique comportant :
- fournir un premier empilement comportant :
o un premier substrat (1) comportant au moins une surface principale munie d'au moins une première zone de contact électrique (6a) et au moins une première protubérance (8a) agencée pour former une butée,
o un deuxième substrat (2) muni d'une entretoise (4) saillante,
- assembler le premier substrat (1) avec le deuxième substrat (2) de manière à définir au moins une première rainure latérale (3a) comportant la première zone de contact électrique (6a) et fixer le premier substrat (1) avec le deuxième substrat (2), la première rainure latérale (3a) étant délimitée par le premier substrat (1), le deuxième substrat (2) et l'entretoise (4), la au moins une première protubérance (8a) limitant le déplacement de l'entretoise (4) par rapport au premier substrat (1) selon au moins une première direction (X) passant par la première rainure latérale (3a) et l'entretoise (4),
procédé **caractérisé en ce que**, lors de la fixation du deuxième substrat (2) avec le premier substrat (1), la au moins une première protubérance (8a) limite le déplacement de l'entretoise (4) par rapport au premier substrat (1) selon une deuxième direction (Y) parallèle à l'axe longitudinal de la première rainure (3a) et perpendiculaire à la première direction (X) et **en ce qu'**il comporte, postérieurement à la fixation du premier substrat (1) avec le deuxième substrat (2), l'élimination au moins partielle de la au moins une première protubérance (8a) au moyen d'une étape de recuit à une température supérieure à la température de fusion du matériau formant la au moins une première protubérance (8a).

2. Procédé de fabrication selon la revendication 1, dans lequel, lors de l'assemblage du deuxième substrat (2) avec le premier substrat (1), le premier substrat (1) comporte, en outre, une deuxième zone de contact électrique (6b) sur ladite au moins une surface principale, la première zone de contact électrique (6a) étant distincte de la deuxième zone de contact électrique (6b), le deuxième substrat (2) étant configuré pour définir avec le premier substrat (1) au moins une deuxième rainure latérale (3b) comportant la deuxième zone de contact électrique (6b), la deuxième rainure latérale (3b) étant séparée de la première rainure latérale (3a) par l'entretoise (4).

3. Procédé de fabrication selon l'une des revendications 1 et 2, dans lequel l'entretoise (4) est fixée au deuxième substrat (2) avant l'assemblage du deuxième substrat (2) avec le premier substrat (1).

4. Procédé de fabrication selon l'une quelconque des revendications précédentes, dans lequel la fixation de l'entretoise (4) avec le premier substrat (1) est réalisée par collage, fusion d'un matériau fusible, scellement moléculaire ou scellement anodique de l'entretoise (4) avec le premier substrat (1).

5. Procédé de fabrication selon l'une quelconque des revendications précédentes, dans lequel la fixation de l'entretoise (4) avec le premier substrat (1) est réalisée en appliquant une contrainte en pression entre le premier substrat (1) et le deuxième substrat (2).

6. Procédé de fabrication selon l'une quelconque des revendications précédentes, dans lequel la fixation de l'entretoise (4) avec le premier substrat (1) est réalisée au moyen d'un traitement thermique.

7. Procédé de fabrication selon l'une quelconque des revendications précédentes dans lequel ladite au moins une première protubérance (8a) est électriquement conductrice et connectée à la première zone de contact électrique (6a), la au moins une première protubérance (8a) étant configurée pour bloquer le déplacement de l'entretoise (4) au moins selon la première direction (X).

8. Procédé de fabrication selon l'une quelconque des revendications précédentes, dans lequel la au moins une première protubérance (8a) définit au moins une butée selon la première direction (X) et l'entretoise (4) comporte une première paroi latérale définissant une première zone en saillie selon la première direction (X), la butée coopérant avec la première zone en saillie pour bloquer le déplacement de l'entretoise (4) selon la deuxième direction (Y).

9. Procédé de fabrication selon l'une quelconque des revendications 2 à 8, dans lequel le premier substrat (1) comporte au moins une deuxième protubérance (8b) électriquement conductrice et connectée à la deuxième zone de contact électrique (6b), la deuxième protubérance (8b) étant configurée pour bloquer le déplacement de l'entretoise (4) au moins selon la première direction (X).

10. Procédé de fabrication selon la revendication précédente, dans lequel la deuxième protubérance (8b) définit au moins une butée selon la première direction (X) et l'entretoise (4) comporte une deuxième paroi latérale opposée à la première paroi latérale et définissant une deuxième zone en saillie selon la première direction (X), la deuxième protubérance (8b) coopérant avec la deuxième zone en saillie pour bloquer le déplacement de l'entretoise (4) selon la deuxième direction (Y), les première et deuxième protubérances (8a, 8b) bloquant l'entretoise (4) selon la première direction (X) et selon la deuxième direction (Y) dans deux sens opposés.

11. Procédé de fabrication selon l'une quelconque des revendications 8 à 10, dans lequel l'entretoise (4) comporte au moins une première portion (4') et une deuxième portion (4"), la première portion (4') ayant une largeur inférieure à la deuxième portion (4"), la largeur étant définie selon la première direction (X), les première et deuxième portions (4', 4") étant disposées consécutivement selon la deuxième direction (Y) pour définir la première zone en saillie.

12. Procédé de fabrication selon la revendication précédente, dans lequel l'entretoise (4) comporte au moins une troisième portion (4"') ayant une largeur supérieure à la largeur de la première portion (4'), la troisième portion (4"') étant séparée de la deuxième portion (4") par la première portion (4') pour définir la deuxième zone en saillie.

13. Procédé de fabrication selon les revendications 10, 11 et 12, dans lequel les première et deuxième zones en saillie sont séparées par la première portion (4') de l'entretoise (4).

14. Procédé de fabrication selon l'une quelconque des revendications précédentes, dans lequel ladite au moins première protubérance (8a) est réalisée dans un matériau de brasure (4).

15. Procédé de fabrication selon la revendication précédente, comportant l'introduction d'au moins un premier fil électriquement conducteur (5a) dans la première rainure latérale (3a), l'étape de recuit transformant le matériau de brasure en un matériau liquide qui recouvre au moins partiellement le premier fil électriquement conducteur (5a) par capillarité.

## Patentansprüche

1. Verfahren zur Herstellung einer elektronischen Einrichtung, umfassend:
- Bereitstellen eines ersten Stapels, umfassend:
∘ ein erstes Substrat (1), umfassend mindestens eine Hauptfläche, die mit mindestens einer ersten elektrischen Kontaktzone (6a) versehen ist, und mindestens einen ersten Vorsprung (8a), der dazu vorgesehen ist, einen Anschlag zu bilden,
∘ ein zweites Substrat (2), das mit einer herausragenden Querstrebe (4) versehen ist,
- Zusammenfügen des ersten Substrats (1) mit dem zweiten Substrat (2), um mindestens eine erste seitliche Nut (3a), umfassend die erste elektrische Kontaktzone (6a) zu definieren und das erste Substrat (1) mit dem zweiten Substrat (2) zu fixieren, wobei die erste seitliche Nut (3a) von dem ersten Substrat (1), dem zweiten Substrat (2) und der Querstrebe (4) begrenzt ist, wobei der mindestens eine erste Vorsprung (8a) die Verlagerung der Querstrebe (4) in Bezug zum ersten Substrat (1) in mindestens eine erste Richtung (X), die durch die erste seitliche Nut (3a) und die Querstrebe (4) verläuft, begrenzt,
wobei das Verfahren **dadurch gekennzeichnet ist, dass** beim Fixieren des zweiten Substrats (2) mit dem ersten Substrat (1) der mindestens eine erste Vorsprung (8a) die Verlagerung der Querstrebe (4) in Bezug zum ersten Substrat (1) in eine zweite Richtung (Y) parallel zur Längsachse der ersten Nut (3a) und senkrecht auf die erste Richtung (X) begrenzt, und dass es nach dem Fixieren des ersten Substrats (1) mit dem zweiten Substrat (2) die zumindest teilweise Beseitigung des mindestens einen ersten Vorsprungs (8a) mit Hilfe einer Glühbehandlung bei einer Temperatur über der Schmelztemperatur des den mindestens einen ersten Vorsprung (8a) bildenden Materials umfasst.

2. Herstellungsverfahren nach Anspruch 1, bei dem beim Zusammenfügen des zweiten Substrats (2) mit dem ersten Substrat (1) das erste Substrat (1) ferner eine zweite elektrische Kontaktzone (6b) auf der mindestens einen Hauptfläche umfasst, wobei sich die erste elektrische Kontaktzone (6a) von der zweiten elektrischen Kontaktzone (6b) unterscheidet, wobei das zweite Substrat (2) eingerichtet ist, um mit dem ersten Substrat (1) mindestens eine zweite seitliche Nut (3b), umfassend die zweite elektrische Kontaktzone (6b), zu definieren, wobei die zweite seitliche Nut (3b) von der ersten seitlichen Nut (3a) durch die Querstrebe (4) getrennt ist.

3. Herstellungsverfahren nach einem der Ansprüche 1 und 2, bei dem die Querstrebe (4) am zweiten Substrat (2) vor dem Zusammenfügen des zweiten Substrats (2) mit dem ersten Substrat (1) fixiert wird.

4. Herstellungsverfahren nach einem der vorhergehenden Ansprüche, bei dem das Fixieren der Querstrebe (4) mit dem ersten Substrat (1) durch Kleben, Schmelzen eines schmelzbaren Materials, molekulare Versiegelung oder Anodenversiegelung der Querstrebe (4) mit dem ersten Substrat (1) erfolgt.

5. Herstellungsverfahren nach einem der vorhergehenden Ansprüche, bei dem das Fixieren der Querstrebe (4) mit dem ersten Substrat (1) durch Anlegen einer Druckspannung zwischen dem ersten Substrat (1) und dem zweiten Substrat (2) erfolgt.

6. Herstellungsverfahren nach einem der vorhergehenden Ansprüche, bei dem das Fixieren der Querstrebe (4) mit dem ersten Substrat (1) mit Hilfe einer Wärmebehandlung erfolgt.

7. Herstellungsverfahren nach einem der vorhergehenden Ansprüche, bei dem der mindestens eine erste Vorsprung (8a) elektrisch leitend ist und an die erste elektrische Kontaktzone (6a) angeschlossen ist, wobei der mindestens eine erste Vorsprung (8a) eingerichtet ist, um die Verlagerung der Querstrebe (4) zumindest in die erste Richtung (X) zu blockieren.

8. Herstellungsverfahren nach einem der vorhergehenden Ansprüche, bei dem der mindestens eine erste Vorsprung (8a) mindestens einen Anschlag in die erste Richtung (X) definiert, und die Querstrebe (4) eine erste Seitenwand umfasst, die eine erste in die erste Richtung (X) vorspringende Zone definiert, wobei der Anschlag mit der ersten vorspringenden Zone zusammenwirkt, um die Verlagerung der Querstrebe (4) in die zweite Richtung (Y) zu blockieren.

9. Herstellungsverfahren nach einem der Ansprüche 2 bis 8, bei dem das erste Substrat (1) mindestens einen zweiten Vorsprung (8b) umfasst, der elektrische leitend ist und an die zweite elektrische Kontaktzone (6b) angeschlossen ist, wobei der zweite Vorsprung (8b) eingerichtet ist, um die Verlagerung der Querstrebe (4) zumindest in die erste Richtung (X) zu blockieren.

10. Herstellungsverfahren nach dem vorhergehenden Anspruch, bei dem der zweite Vorsprung (8b) mindestens einen Anschlag in die erste Richtung (X) definiert, und die Querstrebe (4) eine zweite Seitenwand gegenüber der ersten Seitenwand umfasst, die eine zweite vorspringende Zone in die erste Richtung (X) definiert, wobei der zweite Vorsprung (8b) mit der zweiten vorspringenden Zone zusammenwirkt, um die Verlagerung der Querstrebe (4) in die zweite Richtung (Y) zu blockieren, wobei die ersten und zweiten Vorsprünge (8a, 8b) die Querstrebe (4) in die erste Richtung (X) und in die zweite Richtung (Y) in zwei entgegengesetzte Richtungen blockieren.

11. Herstellungsverfahren nach einem der Ansprüche 8 bis 10, bei dem die Querstrebe (4) mindestens einen ersten Abschnitt (4') und einen zweiten Abschnitt (4'') umfasst, wobei der erste Abschnitt (4') eine geringere Breite als der zweite Abschnitt (4'') hat, wobei die Breite entlang der ersten Richtung (X) definiert ist, wobei die ersten und zweiten Abschnitte (4', 4'') nacheinander entlang der zweiten Richtung (Y) angeordnet sind, um die erste vorspringende Zone zu definieren.

12. Herstellungsverfahren nach dem vorhergehenden Anspruch, bei dem die Querstrebe (4) mindestens einen dritten Abschnitt (4''') mit einer größeren Breite als die Breite des ersten Abschnitts (4') umfasst, wobei der dritte Abschnitt (4''') von dem zweiten Abschnitt (4'') durch den ersten Abschnitt (4') getrennt ist, um die zweite vorspringende Zone zu definieren.

13. Herstellungsverfahren nach den Ansprüchen 10, 11 und 12, bei dem die ersten und zweiten vorspringenden Zonen durch den ersten Abschnitt (4') der Querstrebe (4) getrennt sind.

14. Herstellungsverfahren nach einem der vorhergehenden Ansprüche, bei dem der mindestens eine erste Vorsprung (8a) aus einem Lötmaterial (4) hergestellt ist.

15. Herstellungsverfahren nach dem vorhergehenden Anspruch, umfassend die Einführung mindestens eines ersten elektrisch leitenden Drahtes (5a) in die erste seitliche Nut (3a), wobei die Glühbehandlung das Lötmaterial in ein flüssiges Material umwandelt, das zumindest teilweise den ersten elektrisch leitenden Draht (5a) durch Kapillarität bedeckt.

## Claims

1. Method for fabricating an electronic device comprising :
- providing a first stack comprising:
∘ a first substrate (1) comprising at least one main surface provided with at least a first electric contact area (6a) and at least one first protuberance (8a) arranged to form a stop,
∘ a second substrate (2) provided with a salient spacer (4),
- assembling the first substrate (1) with the second substrate (2) so as to define at least one first lateral groove (3a) comprising the first electric contact area (6a) and to fix the first substrate (1) with the second substrate (2), the first lateral groove (3a) being bounded by the first substrate (1), the second substrate (2) and the spacer (4), the at least a first protuberance (8a) limiting movement of the spacer (4) relatively to the first substrate (1) in at least a first direction (X) passing via the first lateral groove (3a) and the spacer (4),
method **characterised in that**, when fixing of the second substrate (2) with the first substrate (1) is performed, the at least one first protuberance (8a) limits movement of the spacer (4) relatively to the first substrate (1) in a second direction (Y) parallel to the longitudinal axis of the first groove (3a) and perpendicular to the first direction (X) and **in that**, subsequent to fixing of the first substrate (1) with the second substrate (2), it comprises at least partial elimination of the at least one first protuberance (8a) by means of an annealing step at a higher temperature than the melting temperature of the material forming the at least one first protuberance (8a).

2. Method for fabricating according to claim 1, wherein, when assembly of the second substrate (2) with the first substrate (1) is performed, the first substrate (1) further comprises a second electric contact area (6b) on said at least one main surface, the first electric contact area (6a) being distinct from the second electric contact area (6b), the second substrate (2) being configured to define at least one second lateral groove (3b) comprising the second electric contact area (6b) with the first substrate (1), the second lateral groove (3b) being separated from the first lateral groove (3a) by the spacer (4).

3. Method for fabricating according to one of claims 1 and 2, wherein the spacer (4) is fixed to the second substrate (2) before the second substrate (2) is assembled with the first substrate (1).

4. Method for fabricating according to any one of the foregoing claims, wherein fixing of the spacer (4) with the first substrate (1) is performed by bonding, melting of a fusible material, molecular sealing or anodic sealing of the spacer (4) with the first substrate (1).

5. Method for fabricating according to any one of the foregoing claims, wherein fixing of the spacer (4) with the first substrate (1) is performed by applying a pressure stress between the first substrate (1) and the second substrate (2).

6. Method for fabricating according to any one of the foregoing claims, wherein fixing of the spacer (4) with the first substrate (1) is performed by means of a heat treatment.

7. Method for fabricating according to any one of the foregoing claims, wherein said at least a first protuberance (8a) is electrically conducting and connected to the first electric contact area (6a), the at least a first protuberance (8a) being configured to prevent movement of the spacer (4) at least in the first direction (X).

8. Method for fabricating according to any one of the foregoing claims, wherein the at least one first protuberance (8a) defines at least one stop in the first direction (X) and the spacer (4) comprises a first side wall defining a first salient area in the first direction (X), the stop collaborating with the first salient area to prevent movement of the spacer (4) in the second direction (Y).

9. Method for fabricating according to any one of claims 2 to 8, wherein the first substrate (1) comprises at least a second electrically conducting protuberance (8b) connected to the second electric contact area (6b), the second protuberance (8b) being configured to prevent movement of the spacer (4) at least in the first direction (X).

10. Method for fabricating according to the foregoing claim, wherein the second protuberance (8b) defines at least one stop in the first direction (X) and the spacer (4) comprises a second side wall opposite the first side wall and defining a second salient area in the first direction (X), the second protuberance (8b) collaborating with the second salient area to block movement of the spacer (4) in the second direction (Y), the first and second protuberances (8a, 8b) blocking the spacer (4) in the first direction (X) and in the second direction (Y) in two opposite directions.

11. Method for fabricating according to any one of claims 8 to 10, wherein the spacer (4) comprises at least a first portion (4') and a second portion (4"), the first portion (4') having a smaller width than the second portion (4"), the width being defined in the first direction (X), the first and second portions (4', 4") being arranged consecutively in the second direction (Y) to define the first salient area.

12. Method for fabricating according to the foregoing claim, wherein the spacer (4) comprises at least a third portion (4"') having a larger width than the width of the first portion (4'), the third portion (4"') being separated from the second portion (4") by the first portion (4') to define the second salient area.

13. Method for fabricating according to claims 10, 11 and 12, wherein the first and second salient areas are separated by the first portion (4') of the spacer (4).

14. Method for fabricating according to any one of the foregoing claims, wherein said at least first protuberance (8a) is made from a brazing material (4).

15. Method for fabricating according to the foregoing claim, comprising insertion of at least a first electrically conducting wire (5a) in the first lateral groove (3a), the annealing step transforming a brazing material into a liquid material that at least partially covers the first electrically conducting wire (5a) by capillarity.
